# EUROPEAN PATENT SPECIFICATION

(11) **EP 2 095 948 B1**
(45) Date of publication and mention of the grant of the patent: **15.09.2010**
(21) Application number: 08102122.2
(22) Date of filing: 28.02.2008
(51) Int. Cl.: B41C 1/10, G03F 7/32

(54) **A method for making a lithographic printing plate**
Verfahren zur Herstellung einer Lithografiedruckplatte
Procédé pour fabrication d'une plaque d'impression lithographique

(43) Date of publication of application: 02.09.2009
(73) Proprietor: Agfa Graphics N.V., 2640 Mortsel (BE)
(72) Inventor: Campestrini, Paola, 2640, Mortsel (BE); Lingier, Stefaan, 2640, Mortsel (BE)

(56) References cited:
- EP-A- 1 614 539

## Description

### FIELD OF THE INVENTION

The present invention relates to a method for making a lithographic printing plate.

### BACKGROUND OF THE INVENTION

Lithographic printing presses use a so-called printing master such as a printing plate which is mounted on a cylinder of the printing press. The master carries a lithographic image on its surface and a print is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Printing masters are generally obtained by the image-wise exposure and processing of an imaging material called plate precursor. In addition to the well-known photosensitive, so-called pre-sensitized plates, which are suitable for UV contact exposure through a film mask, also heat-sensitive printing plate precursors have become very popular in the late 1990s. Such thermal materials offer the advantage of daylight stability and are especially used in the so-called computer-to-plate method wherein the plate precursor is directly exposed, i.e. without the use of a film mask. The material is exposed to heat or to infrared light and the generated heat triggers a (physico-)chemical process, such as ablation, polymerization, insolubilization by cross linking of a polymer, heat-induced solubilization, or particle coagulation of a thermoplastic polymer latex.

The most popular thermal plates form an image by a heat-induced solubility difference in an alkaline developer between exposed and non-exposed areas of the coating. The coating typically comprises an oleophilic binder, e.g. a phenolic resin, of which the rate of dissolution in the developer is either reduced (negative working) or increased (positive working), by the image-wise exposure. During processing, the solubility differential leads to the removal of the non-image (non-printing) areas of the coating, thereby revealing the hydrophilic support, while the image (printing) areas of the coating remain on the support. Typical examples of such plates are described in e.g. EP-As 625 728, 823 327, 825 927, 864 420, 894 622 and 901 902. Negative working embodiments of such thermal materials often require a pre-heat step between exposure and development as described in e.g. EP-A 625 728.

Negative working plate precursors which do not require a pre-heat step may contain an image-recording layer that works by heat-induced particle coalescence of a thermoplastic polymer latex, as described in e.g. EP-As 770 494, 770 495, 770 496 and 770 497. These patents disclose a method for making a lithographic printing plate comprising the steps of (1) image-wise exposing an imaging element comprising hydrophobic thermoplastic polymer particles dispersed in a hydrophilic binder and a compound capable of converting light into heat and (2) developing the image-wise exposed element by applying fountain and/or ink.

EP-A 1 342 568 describes a method of making a lithographic printing plate comprising the steps of (1) image-wise exposing an imaging element comprising hydrophobic thermoplastic polymer particles dispersed in a hydrophilic binder and a compound capable of converting light into heat and (2) developing the image-wise exposed element by applying a gum solution, thereby removing non-exposed areas of the coating from the support.

WO2006/037716 describes a method for preparing a lithographic printing plate which comprises the steps of (1) image-wise exposing an imaging element comprising hydrophobic thermoplastic polymer particles dispersed in a hydrophilic binder and a compound capable of converting light into heat and (2) developing the image-wise exposed element by applying a gum solution, thereby removing non-exposed areas of the coating from the support and characterised by an average particle size of the thermoplastic polymer particles between 40 nm and 63 nm and wherein the amount of the hydrophobic thermoplastic polymer particles is more than 70 % and less than 85 % by weight, relative to the image recording layer.

EP-A 1 614 538 describes a negative working lithographic printing plate precursor which comprises a support having a hydrophilic surface or which is provided with a hydrophilic layer and a coating provided thereon, the coating comprising an image-recording layer which comprises hydrophobic thermoplastic polymer particles and a hydrophilic binder, **characterised in that** the hydrophobic thermoplastic polymer particles have an average particle size in the range from 45 nm to 63 nm, and that the amount of the hydrophobic thermoplastic polymer particles in the image-recording layer is at least 70 % by weight relative to the image-recording layer.

EP-A 1 614 539 and EP-A 1 614 540 describes a method of making a lithographic printing plate comprising the steps of (1) image-wise exposing an imaging element disclosed in EP-A 1 614 538 and (2) developing the image-wise exposed element by applying an aqueous, alkaline solution.

A problem sometimes encountered with lithographic printing plates prepared according to the method as described in EP-A 1 614 539 or EP-A 1 614 540 is a poor restart performance after a press stop. Such press stops may occur for example due to shortage of paper or due to a lunch break for the operators. It has been noticed that when the press is restarted, a bad clean out, i.e. ink acceptance in the non-image areas of the printing plate, is sometimes observed. Often, several tens up to hundreds sheets of paper have to be printed after the restart to obtain again a good clean out of the printing plates.

### SUMMARY OF THE INVENTION

It is an object of the present invention to provide a method of preparing lithographic printing plates from thermosensitive lithographic printing plate precursors having thermoplastic particles in their image-recording layer **characterized in that** these printing plates have an improved clean out during the restart of a printing press after a press stop.

It has been found that this object is realized by the method of preparing a lithographic printing plate as defined in claim 1.

Another object of the present invention is to provide a method of printing wherein a lithographic printing plate prepared according to the method as defined in claim 1 is used.

Other preferred embodiments of the present invention are described in the dependent claims.

### DETAILED DESCRIPTION OF THE INVENTION

The printing plate precursor, used in the method for making a printing plate, comprises a coating on a support having a hydrophilic surface. The coating may comprise one or more layer(s). The layer of the coating comprising thermoplastic particles is referred to as the image-recording layer.

### Thermoplastic particles

The thermoplastic particles preferably have an average particle diameter from 15 nm to 75 nm, more preferably from 25 to 55 nm, most preferably from 35 nm to 45 nm. The average particle diameter referred to in the claims and the description of this application is meant to be the average particle diameter measured by Photon Correlation Spectrometry, also known as Quasi-Elastic or Dynamic Light-Scattering, unless otherwise specified. The measurements were performed according the ISO 13321 procedure (first edition, 1996-07-01) with a Brookhaven BI-90 analyzer, commercially available from Brookhaven Instrument Company, Holtsville, NY, USA.

The amount of thermoplastic polymer particles is preferably at least 50, more preferably at least 60, most preferably at least 70 % by weight relative to the total weight of all the ingredients in the image-recording layer.

The thermoplastic polymer particles which are present in the coating may be selected from polyethylene, poly(vinyl)chloride, polymethyl(meth)acrylate, polyethyl (meth)acrylate, polyvinylidene chloride, poly(meth)acrylonitrile, polyvinylcarbazole, polystyrene or copolymers thereof.

According to a preferred embodiment, the thermoplastic polymer particles comprise polystyrene or derivatives thereof, mixtures comprising polystyrene and poly(meth)acrylonitrile or derivatives thereof, or copolymers comprising styrene and (meth)acrylonitrile or derivatives thereof. The latter copolymers may comprise at least 30 % by weight of polystyrene, more preferably at least 50 % by weight of polystyrene. In order to obtain sufficient resistivity towards organic chemicals such as hydrocarbons used in e.g. plate cleaners, the thermoplastic polymer particles preferably comprise at least 5 % by weight, more preferably at least 30 % by weight, of nitrogen containing units, such as (meth)acrylonitrile, as described in EP-A 1 219 416. According to the most preferred embodiment, the thermoplastic polymer particles consist essentially of styrene and acrylonitrile units in a weight ratio between 1:1 and 5:1 (styrene:acrylonitrile), e.g. in a 2:1 ratio.

The thermoplastic polymer particles may also comprise polymers or copolymers rendering the particles self-dispersible in an aqueous solution as for example disclosed in EP-As 1 834 764 and 1 157 829.

The thermoplastic polymer particles comprise preferably a polymer or co-polymer having a weight average molecular weight ranging from 5 000 to 1 000 000 g/mol.

The thermoplastic polymer particles can be prepared by addition polymerization or by condensation polymerization. They are preferably applied onto the lithographic base as dispersions in an aqueous coating liquid. These water based dispersions can be prepared by polymerization in a water-based system e.g. by free-radical emulsion polymerization as described in US 3 476 937 or EP-A 1 217 010, or by means of dispersing techniques of the water-insoluble polymers into water. Another method for preparing an aqueous dispersion of the thermoplastic polymer particles comprises (1) dissolving the hydrophobic thermoplastic polymer in an organic water immiscible solvent, (2) dispersing the thus obtained solution in water or in an aqueous medium and (3) removing the organic solvent by evaporation. Emulsion polymerization is typically carried out through controlled addition of several components - i.e. vinyl monomers, surfactants (dispersion aids), initiators and optionally other components such as buffers or protective colloids - to a continuous medium, usually water. The resulting polymer of the emulsion polymerization is a dispersion of discrete particles in water. The surfactants or dispersion aids which are present in the reaction medium have a multiple role in the emulsion polymerization: (1) they reduce the interfacial tension between the monomers and the aqueous phase, (2) they provide reaction sites through micelle formation in which the polymerization occurs and (3) they stabilize the growing polymer particles and ultimately the latex emulsion. The surfactants are adsorbed at the water/polymer interface and thereby prevent coagulation of the fine polymer particles. Non-ionic, cationic and anionic surfactants may be used in emulsion polymerization. Preferably non-ionic and anionic surfactants are used. Most preferably the hydrophobic thermoplastic particles are stabilized with an anionic dispersion aid. Specific examples of suitable anionic dispersion aids include sodium lauryl sulphate, sodium lauryl ether sulphate, sodium dodecyl sulphate, sodium dodecyl benzene sulphonate and sodium lauryl phosphate; suitable non-ionic dispersion aids are for example ethoxylated lauryl alcohol and ethoxylated octyl or nonyl phenol.

### IR absorbing compounds

The coating may contain a dye which absorbs infrared (IR) radiation and converts the absorbed energy into heat. Preferred IR absorbing dyes are cyanine, merocyanine, indoaniline, oxonol, pyrilium and squarilium dyes. Examples of suitable IR absorbers are described in e.g. EP-As 823 327, 978 376, 1 029 667, 1 053 868 and 1 093 934 and WOs 97/39894 and 00/29214.

Other preferred IR-dyes are described in EP-A 1 614 541 (page 20 line 25 to page 44 line 29) and EP-A 1 736 312 (paragraphs [0008] to [0021]) and WO2006136543.

Preferred IR-dyes are water compatible, most preferably, water soluble.

The IR-dye amount is preferably at least 6 % by weight, more preferably at least 8 % by weight, relative to the total weight of the ingredients of the image recording layer.

As described in EP-A 1 859 936 the amount of IR-dye may be adjusted to the particle size of the thermoplastic particles.

### Binder

The image-recording layer may further comprise a hydrophilic binder. Examples of suitable hydrophilic binders are homopolymers and copolymers of vinyl alcohol, (meth)acrylamide, methylol (meth)acrylamide, (meth)acrylic acid, hydroxyethyl (meth)acrylate, maleic anhydride/vinylmethylether copolymers, copolymers of (meth)acrylic acid or vinylalcohol with styrene sulphonic acid. Preferably, the hydrophilic binder comprises polyvinylalcohol or polyacrylic acid.

The amount of hydrophilic binder may be between 2.5 and 50 % by weight, preferably between 3 and 20 % by weight, more preferably between 4 and 10 % by weight relative to the total weight of all ingredients of the image-recording layer.

The amount of the hydrophobic thermoplastic polymer particles relative to the amount of the binder is preferably between 8 and 20, more preferably between 10 and 18, most preferably between 12 and 16.

### Contrast Dyes

Colorants, such as dyes or pigments, which provide a visible color to the coating and remain in the exposed areas of the coating after the processing step may be added to the coating. The image-areas, which are not removed during the processing step, form a visible image on the printing plate and examination of the lithographic image on the developed printing plate becomes feasible. Typical examples of such contrast dyes are the amino-substituted tri- or diarylmethane dyes, e.g. crystal violet, methyl violet, victoria pure blue, flexoblau 630, basonylblau 640, auramine and malachite green. Also the dyes which are discussed in depth in the detailed description of EP-A 400 706 are suitable contrast dyes. Dyes which, combined with specific additives, only slightly color the coating but which become intensively colored after exposure, as described in for example WO2006/005688 are also of interest.

Other preferred contrast dyes are those described in EP-A-1 914 069.

Typical contrast dyes may be combined, or even replaced by the IR dyes as described in EP-A 1 614 541 and WO2006136543 since these IR dyes form a visible color upon exposure to IR radiation.

### Other ingredients

Optionally, the coating may further contain additional ingredients. These ingredients may be present in the image-recording layer or in an optional other layer. For example, additional binders, polymer particles such as matting agents and spacers, surfactants such as perfluoro-surfactants, silicon or titanium dioxide particles, development inhibitors, development accelerators, colorants, metal complexing agents are well-known components of lithographic coatings.

Preferably the image-recording layer comprises an organic compound, **characterised in that** said organic compound comprises at least one phosphonic acid group or at least one phosphoric acid group or a salt thereof, as described in WO2007/045515. In a particularly preferred embodiment the image-recording layer comprises an organic compound as represented by formula I: 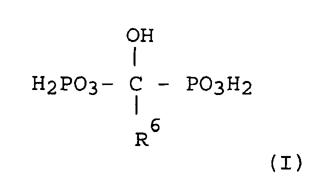 or a salt thereof and wherein R⁶ independently represent hydrogen, an optionally substituted straight, branched, cyclic or heterocyclic alkyl group or an optionally substituted aryl or heteroaryl group. Compounds according to formula I may be present in the image-recording layer in an amount between 0.05 and 15 % by weight, preferably between 0.5 and 10 % by weight, more preferably between 1 and 5 % by weight relative to the total weight of the ingredients of the image-recording layer.

To avoid degradation of the print out image formed after exposure and development, especially when the print out image is formed by the IR dyes mentioned above, a light stabilizer or anti-oxidant may be present in the coating. Preferred stabilizers, such as ascorbic or isoascorbic acid derivatives, are disclosed in EP-A-1 974 911.

### Other layers of the coating

To protect the surface of the coating, in particular from mechanical damage, a protective layer may optionally be applied on the image-recording layer. The protective layer generally comprises at least one water-soluble polymeric binder, such as polyvinyl alcohol, polyvinylpyrrolidone, partially hydrolyzed polyvinyl acetates, gelatin, carbohydrates or hydroxyethylcellulose. The protective layer may contain small amounts, i.e. less then 5 % by weight, of organic solvents.

The IR dye mentioned above may be present in the image-recording layer or in the protective layer, or in both.

The thickness of the protective layer is not particularly limited but preferably is up to 5.0 µm, more preferably from 0.05 to 3.0 µm, particularly preferably from 0.10 to 1.0 µm.

The coating may further contain other additional layer(s) such as for example an adhesion-improving layer located between the image-recording layer and the support.

The coating may be applied on the support by any coating technique known in the art. After applying the coating, the applied layer(s) are dried as commonly known in the art. While drying the coating, in particular the image-recording layer, it is preferred to keep the temperature, measured as the wet coating temperature, below 45°c, more preferably below 40°C, most preferably below 35°C and to keep the temperature, measured as the dry coating temperature, below 90°C, more preferably below 60°C.

### Support

The support of the lithographic printing plate precursor has a hydrophilic surface or is provided with a hydrophilic layer. The support may be a sheet-like material such as a plate or it may be a cylindrical element such as a sleeve which can be slid around a print cylinder of a printing press.

In one embodiment of the invention the support is a metal support such as aluminum or stainless steel. The support can also be a laminate comprising an aluminum foil and a plastic layer, e.g. polyester film. A particularly preferred lithographic support is an aluminum support. Any known and widely used aluminum materials can be used. The aluminum support has a thickness of about 0.1-0.6 mm. However, this thickness can be changed appropriately depending on the size of the printing plate used and the plate-setters on which the printing plate precursors are exposed.

To optimize the lithographic properties, the aluminum support is subjected to several treatments well known in the art such as for example: degrease, surface roughening, etching, anodization, sealing, surface treatment. In between such treatments, a neutralization treatment is often carried out. A detailed description of these treatments can be found in e.g.

EP-As 1 142 707, 1 564 020 and 1 614 538. Preferred treatments are the application of e.g. a polyvinylphosphonic acid or ester, a zirconium salt, a silicate or mixtures thereof, applied together or sequential to the surface of the support.

A preferred aluminum substrate, characterized by an arithmetical mean center-line roughness Ra less then 0.45 µ is described in EP 1 356 926.

Optimizing the pore diameter and distribution thereof of the grained and anodized aluminum surface as described in EP 1 142 707 and US 6 692 890 may enhance the press life of the printing plate and may improve the toning behaviour. Avoiding large and deep pores as described in US 6 912 956 may also improve the toning behaviour of the printing plate. An optimal ratio between pore diameter of the surface of the aluminum support and the average particle size of the thermoplastic particles may enhance the press run length of the plate and may improve the toning behaviour of the prints. This ratio of the average pore diameter of the surface of the aluminum support to the average particle size of the thermoplastic particles present in the image-recording layer of the coating, preferably ranges from 0.1 to 0.8, more preferably from 0.2 to 0.5.

Alternative supports for the plate precursor can also be used, such as amorphous metallic alloys (metallic glasses). Such amorphous metallic alloys can be used as such or joined with other non-amorphous metals such as aluminum. Examples of amorphous metallic alloys are described in US 5 288 344, US 5 368 659, US 5 618 359, US 5 735 975, US 5 250 124, US 5 032 196, US 6 325 868, and

US 6 818 078. The following references describe the science of amorphous metals in much more detail and are incorporated as references: Introduction to the Theory of Amorphous Metals, N.P. Kovalenko et al.(2001); Atomic Ordering in Liquid and Amorphous Metals, S.I. Popel, et al; Physics of Amorphous Metals, N.P. Kovalenko et al (2001).

According to another embodiment, the support can also be a flexible support, which is provided with a hydrophilic layer. The flexible support is e.g. paper, plastic film, thin aluminum or a laminate thereof. Preferred examples of plastic film are poly-ethylene terephthalate film, polyethylene naphthalate film, cellulose acetate film, polystyrene film, polycarbonate film, etc. The plastic film support may be opaque or transparent. Particular examples of suitable hydrophilic layers that may be supplied to a flexible support for use in accordance with the present invention are disclosed in EP-A 601 240, GB 1 419 512, FR 2 300 354, US 3 971 660, US 4 284 705, EP 1 614 538, EP 1 564 020 and US 2006/0019196.

### Exposure

Preferably, the printing plate precursor is imagewise exposed with infrared radiation, preferably near infrared radiation. The infrared radiation is converted into heat by an IR-dye as discussed above. The heat-sensitive lithographic printing plate precursor of the present invention is preferably not sensitive to visible radiation. Most preferably, the coating is not sensitive to ambient daylight, i.e. visible (400-750 nm) and near UV radiation (300-400 nm) at an intensity and exposure time corresponding to normal working conditions so that the material can be handled without the need for a safe light environment.

The printing plate precursors of the present invention can be exposed to infrared radiation by means of e.g. LEDs or an infrared laser. Preferably lasers, emitting near infrared radiation having a wavelength in the range from about 700 to about 1500 nm, e.g. a semiconductor laser diode, a Nd:YAG or a Nd:YLF laser, are used. Most preferably, a laser emitting in the range between 780 and 830 nm is used. The required laser power depends on the sensitivity of the image-recording layer, the pixel dwell time of the laser beam, which is determined by the spot diameter (typical value of modern plate-setters at 1/e² of maximum intensity : 10-25 µm), the scan speed and the resolution of the exposure apparatus (i.e. the number of addressable pixels per unit of linear distance, often expressed in dots per inch or dpi; typical value : 1000-4000 dpi).

In a preferred embodiment of this invention a useful lithographic image is obtained upon image-wise exposure of the printing plate precursor with IR radiation having an energy density, measured at the surface of said precursor, of 200 mJ/cm² or less, more preferably of 180 mJ/cm² or less, most preferably of 160 mJ/cm² or less. With a useful lithographic image on the printing plate, 2 % dots (at 200 lpi) are perfectly visible on at least 1 000 prints on paper.

Two types of laser-exposure apparatuses are commonly used: internal (ITD) and external drum (XTD) plate-setters. ITD plate-setters for thermal plates are typically characterized by a very high scan speed up to 1500 m/s and may require a laser power of several Watts. The Agfa Galileo T (trademark of Agfa Graphics N.V.) is a typical example of a plate-setter using the ITD-technology. XTD plate-setters for thermal plates having a typical laser power from about 20 mW to about 500 mW per laser beam operate at a lower scan speed, e.g. from 0.1 to 20 m/s. The Agfa Xcalibur, Accento and Avalon plate-setter families (trademark of Agfa Graphics N.V.) make use of the XTD-technology.

Due to the heat generated during the exposure step, the thermoplastic polymer particles may fuse or coagulate thereby forming a hydrophobic phase which corresponds to the printing areas of the printing plate. Coagulation may result from heat-induced coalescence, softening or melting of the thermoplastic polymer particles. There is no specific upper limit to the coagulation temperature of the thermoplastic polymer particles, however the temperature should be sufficiently below the decomposition temperature of the polymer particles. Preferably the coagulation temperature is at least 10 °C below the temperature at which the decomposition of the polymer particles occurs. The coagulation temperature is preferably higher than 50 °C, more preferably above 100 °C.

As an alternative, the printing plate precursor may be imagewise heated by a heating element to form an image.

### Development

After exposure, the material is developed by supplying to the coating an aqueous alkaline solution comprising at least 0.05 g/l, preferably at least 0.1 g/l, more preferably at least 0.25 g/l of lithium ions, whereby the non-image areas of the coating are removed.

The developing step with the aqueous alkaline developer solution may be combined with mechanical rubbing, preferably by one or more rotating brushes, to better remove the non-images parts of the precursor. Preferred rotating brushes are described in US2007/0184387 (paragraphs [0255] to [0257]).

Development is preferably carried out by spraying the developing solution onto the precursor, i.e. spray development, or by dipping the precursor into the developing solution. Preferably, the development is carried out in an automatic processor equipped with supplying means for the developer and the rubbing members.

During the development step, any water-soluble protective layer present is also removed. A protective overcoat may also be removed by carrying out a pre-wash before development.

A preferred developer solution is an aqueous alkaline solution comprising at least 0.05 g/l of lithium ions and having a pH of at least 9, preferably at least 10, more preferably at least 11, most preferably at least 12. There is no particular upper limit of the lithium ion concentration in the alkaline aqueous solution. However, the aqueous solution is preferably free from any crystallisation phenomena.

The lithium ions may be introduced in the developer by adding a lithium salt to the developer. The lithium ions may be added in the form of organic salts like for example lithium benzoate, lithium citrate or lithium acetate. Preferably, the lithium ion are introduced in the developer by inorganic salts. Suitable inorganic lithium salts include lithium chloride, lithium perchlorate, lithium bromide, lithium tetraborate, lithium phosphate, lithium silicates, lithium nitrate, lithium hydroxide, lithium carbonate and lithium sulfate. The lithium may be introduced in the developer by one lithium salt or by two or more different lithium salts.

The developer comprises an alkaline agent. In a preferred embodiment said alkaline agent comprises an alkaline silicate or metasilicate. The alkaline silicate or metasilicate exhibits an alkalinity when dissolved in water, and examples thereof include an alkali metal silicate and alkali metal metasilicate such as sodium silicate, sodium metasilicate, potassium silicate and lithium silicate, and ammonium silicate. Said alkaline silicate may be used alone, or in combination with another alkaline agent. The development performance of the alkaline aqueous solution may be easily modulated by adjusting the molar ratio of alkaline silicates and alkali metal hydroxides, represented by silicon oxide (SiO₂) and an alkali oxide (M₂O, wherein M represents an alkali metal or an ammonium group). The alkaline aqueous solution has preferably a molar ratio SiO₂/M₂O from 0.5 to 3.0, more preferably from 1.0 to 2.0, most preferably of 1.0. The concentration of alkaline silicate in the developer ranges generally from 1 to 14 weight %, preferably from 3 to 14 weight %, and more preferably from 4 to 14% weight %.

In another embodiment, the aqueous alkaline solution may comprise a nonreducing sugar. The nonreducing sugar denotes sugars having no reductive property due to the absence of a free aldehyde group or a free ketone group. Said nonreducing sugar is classified into trehalose-type oligosaccharides wherein a reductive group and another reductive group make a linkage; glycosides wherein a reductive group in a sugar is linked to a non-sugar compound; and sugar alcohols which are produced by reducing a sugar with hydrogenation. Said trehalose-type oligosaccharides include sucrose and trehalose, and said glycosides include alkyl glycosides, phenol glycosides, mustard oil glycosides and the like. Said sugar alcohols include D,L-arabitol, ribitol, xylitol, D,L-sorbitol, D,L-mannitol, D,L-iditol, talitol, dulcitol, allodulcitol and the like. Further, maltitol obtained by hydrogenation of disaccharide, a reduced material obtained by hydrogenation of oligosaccharide (a reduced starch syrup) and the like are preferably used. Pentaerythritol can also be used in the developing solution.

Of the above mentioned nonreducing sugars, preferred are sugar alcohols and sucrose, and particularly preferred are D-sorbitol, sucrose and a reduced starch syrup, since they have buffering action in appropriate pH range.

In addition to alkali metal silicates and/or nonreducing sugars, the developer may optionally contain further components, such as buffer substances, complexing agents, antifoams, organic solvents in small amounts, corrosion inhibitors, dyes, surfactants and/or hydrotropic agents as known in the art.

In a preferred embodiment, the aqueous alkaline solution further comprises a mono alkali metal or ammonium salt of an organic carboxylic acid, having 4 to 12 carbon atoms and substituted with 3 to 11 hydroxyl groups. Said organic carboxylic acid is more preferably a sugar acid, i.e. a sugar compound having a carboxylic acid group. The sugar acids have preferably at least 3 hydroxyl groups, more preferably at least 4 hydroxyl groups, most preferably at least 5 hydroxyl groups. The sugar acids have preferably at most 11 hydroxyl groups, more preferably at most 7 hydroxyl groups, most preferably at most 6 hydroxyl groups. Said sugar acids include gluconic acid, D-glucaric acid, pentaric acid, D-galacturonic acid, D-glucuronic acid, heptonic acid, D-gluco-heptonic acid, tartaric acid, erythronic acid, L-arabinoic acid, D-arabino-2-hexulosonic acid, glucopyranuronic acid and muramic acid. Preferred examples are gluconic acid, D-gluco-heptonic acid and L-arabinoic acid. Gluconic acid is highly preferred in the developing solution of the present invention. It has been observed that the presence of a mono alkali metal or ammonium salt of an organic carboxylic acid, having 4 to 12 carbon atoms and substituted with 3 to 11 hydroxyl groups, in combination with the presence of the lithium ions in the developing solution may result in even better clean out properties during the restart of the printing press. A preferred amount of the mono alkali metal or ammonium salt of an organic carboxylic acid, having 4 to 12 carbon atoms and substituted with 3 to 11 hydroxyl groups, for example of gluconic acid, is at least 0.025 mol/l, more preferably at least 0.04 mol/l, most preferably at least 0.08 mol/l. The molar ratio of lithium ions to gluconic acid, is preferably between 0.3 and 10.0, more preferably between 0.6 and 7.0, most preferably between 0.9 and 4.0.

Development is preferably carried out at temperatures of from 20 to 40°C in automated processing units as customary in the art.

For replenishment (also called regeneration) purposes, alkali metal silicate solutions having alkali metal contents of from 0.6 to 2.0 mol/l can suitably be used. These solutions may have the same silica/alkali metal oxide ratio as the developer and optionally contain further additives. Replenishment may be tailored to the developing apparatuses used, daily plate throughputs, image areas, etc. and are in general from 1 to 50 ml per square meter of plate precursor. Addition of replenisher can be regulated, for example, by measuring the conductivity of the developer as described in EP-A 0 556 690.

The development step may be followed by a rinsing step and/or a gumming step. The gumming step involves post-treatment of the lithographic printing plate with a gum solution. A gum solution is typically an aqueous liquid which comprises one or more surface protective compounds that are capable of protecting the lithographic image of a printing plate against contamination or damaging. Suitable examples of such compounds are film-forming hydrophilic polymers or surfactants.

The plate precursor can, if required, be post-treated with a suitable correcting agent or preservative as known in the art.

To increase the resistance of the finished printing plate and hence to extend the run length, the layer can be briefly heated to elevated temperatures ("baking"). The plate can be dried before baking or is dried during the baking process itself. During the baking step, the plate can be heated at a temperature which is higher than the glass transition temperature of the thermoplastic particles, e.g. between 100°C and 230°C for a period of 40 minutes to 5 minutes. A preferred baking temperature is above 60°C. For example, the exposed and developed plates can be baked at a temperature of 230°C for 5 minutes, at a temperature of 150°C for 10 minutes or at a temperature of 120°C for 30 minutes. Baking can be done in conventional hot air ovens or by irradiation with lamps emitting in the infrared or ultraviolet spectrum. As a result of this baking step, the resistance of the printing plate to plate cleaners, correction agents and UV-curable printing inks increases.

A baking process as disclosed in EP 1 767 349 may also be applied in the present invention.

The printing plate thus obtained can be used for conventional, so-called wet offset printing, in which ink and an aqueous dampening liquid is supplied to the plate. Another suitable printing method uses so-called single-fluid ink without a dampening liquid. Suitable single-fluid inks have been described in US 4 045 232; US 4 981 517 and US 6 140 392. In a most preferred embodiment, the single-fluid ink comprises an ink phase, also called the hydrophobic or oleophilic phase, and a polyol phase as described in WO 00/32705.

In another preferred embodiment, development off press with e.g. a developing solution, wherein the non-exposed areas of the image recording layer are partially removed, may be combined with a development on press, wherein a complete removal of the non-exposed is realised.

### EXAMPLES

### Materials

- :AMIGO; a heat sensitive printing plate precursor comprising thermoplastic particles, available from Agfa Graphics NV.
- Sodium gluconate; available from Roquette Frères SA (France).
- Potassium silicate; 41.5 wt.% in water from PQ Nederland B.V. with a typical Si0₂/K₂0 weight ratio of 0.93.
- Antifoam(1);Contraspum W CONC, a 25 wt.% silicon emulsion in water from Zchimmer & Schwarz Italiana S.p.A.
- Antifoam(2); Foam Ban MS-575, a 75 wt.% silicon emulsion in water from Munzing Chemie GmbH.
- Genapol C200; 10 wt.% in water of a coconut fatty alcohol ethoxylate from Clariant GmbH.
- Proxel Ultra5; 6 wt.% of 1,2-benzisothiazolin-3-one in water, a biocide from Avecia Ltd.
- Ralufon DCH; 50 wt.% of N,N-dimethyl-N-coco-N-(3-sulfopropyl) ammonium betaine in water, from Raschig GmbH.
- LiN0₃; 98 % from Chemsyntha N.V.
- LiOH; 98 % from Merck KGaA.
- RC795; a gum solution available from Agfa Graphics NV.

### EXAMPLE 1

### Developers DEV-01 to DEV-06

The developers DEV-01 to DEV-06 of which the composition is shown in Table 1 were prepared by mixing the ingredients together.

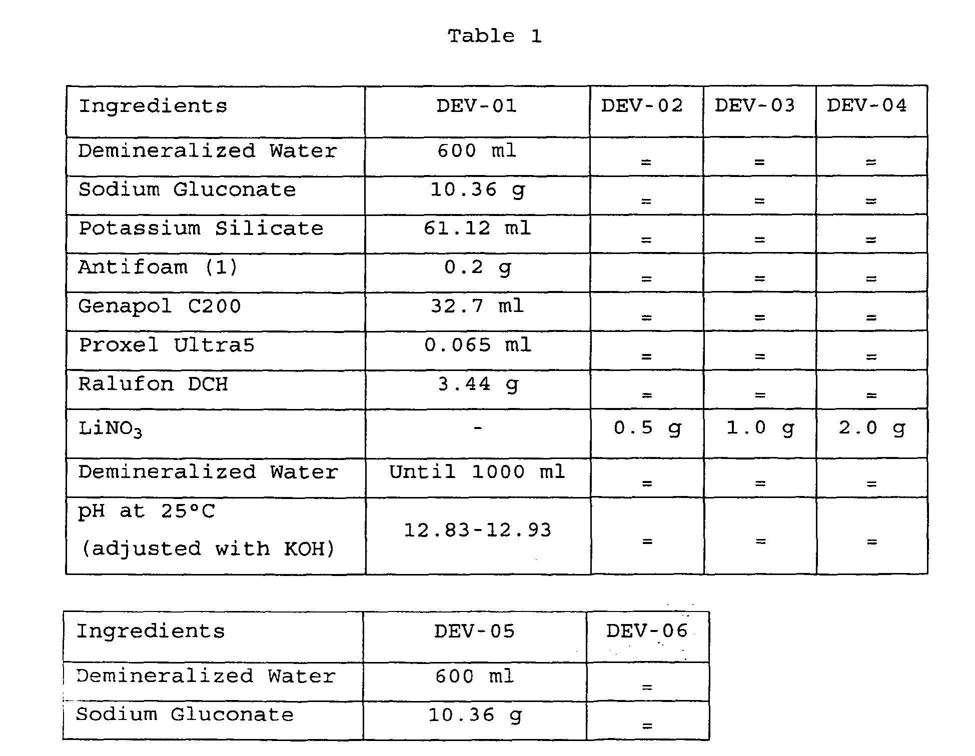

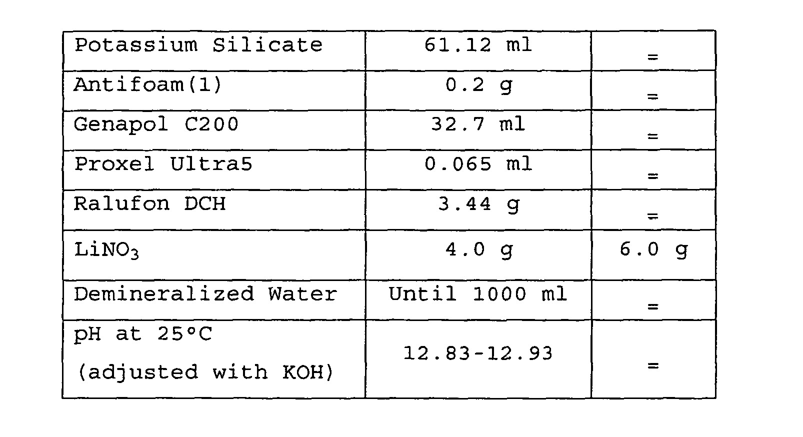

### Exposing the lithographic printing plate precursors

Test patterns were exposed on several :AMIGO printing plate precursors with a Creo TrendSetter 3244 (Trademark of Creo Products Inc.) equipped with a 40 W imaging head at an energy density of 200 mJ/cm² (drum speed of 150 rpm and addressability of 2400 dpi).

### Developing the exposed lithographic printing plate precursors

The exposed printing plate precursors were cut in strips and each strip was developed by dipping during 15 seconds at room temperature (22°C) in a circulating tank containing respectively the developers DEV-01 to DEV-06. Subsequently, each strip was rinsed with demineralised water at room temperature, dried and gummed in the gum section of an Elantrix H85 processor (available from Agfa Graphics NV), with a 1:1 diluted RC795 gum at room temperature (dwell time was 25.0 seconds).

### Printing of the developed printing plate precursors

All developed strips were taped together next to each other in order to be able to mount them on a printing press. Printing on machine coated paper (90 mg/m²) was performed on a Heidelberg GTO52 sheetfed press equipped with a Dahlgren dampening system at a printing speed of 5 000 sheets per hour. Printing was done with a K+E 800 black ink (Trademark of K+E) and 4 % Agfa Prima FS303SF (commercially available from Agfa Graphics NV) + 10 % IPA (isopropylalcohol) as fountain solution. A compressible type of blanket was used. Printing was started for all examples within four hours after development and gumming of the plates.

The following start-up procedure was used: first 10 revolutions with the dampening form rollers engaged, then 5 revolutions with both the dampening and ink form rollers engaged, then start printing. The printing target density was 1.75 +/- 0.05 as measured with a GretagMacBeth D186 or D19c densitometer equipped with a polarization filter. After printing 500 sheets, the press was stopped and the plate cylinder was turned in a position where the image on the plate was positioned under the inking form rollers. After 15 minutes, the press was started again, but this time a different start-up procedure was followed: first 5 revolution with the dampening form rollers engaged, then 5 revolutions with both the dampening and ink form rollers engaged, then start printing. Subsequently, 250 sheets were printed and evaluated.

### Evaluation of the restart performance

The printing plates, developed in the different developers DEV-01 to DEV-06 were qualitatively evaluated according to the following evaluation scale:
- 0 = clean-out not OK after 250 sheets
- 1 = clean-out OK after 250 sheets
- 2 = clean-out OK after 100 sheets
- 3 = clean-out OK after 25 sheets
- 4 = clean-out OK after 10 sheets
- 5 = clean-out OK on the first sheet

The results of the evaluation are shown in Table 2.

**Table 2**

| Developer | Restart performance | Lithium (g/l) |
|---|---|---|
| DEV-01 (COMP) | 0 | 0 |
| DEV-02 (INV) | 2 | 0.05 |
| DEV-03 (INV) | 3 | 0.10 |
| DEV-04 (INV) | 3 | 0.20 |
| DEV-05 (INV) | 4 | 0.40 |
| DEV-06 (INV) | 4 | 0.60 |

It is clear from Table 2 that printing plates obtained after processing the precursor in the inventive developers (DEV-02 to DEV-06) all containing at least 0.05 g/l lithium ions are characterized by a substantial improvement of the restart behaviour.

### EXAMPLE 2

### Developer concentrates DEVC-01 to DEVC-06

Developer concentrates (for dilution 1+8 with water) DEVC-01 to DEVC-06 of which the composition is shown in Table 3 were prepared by mixing the ingredients together.

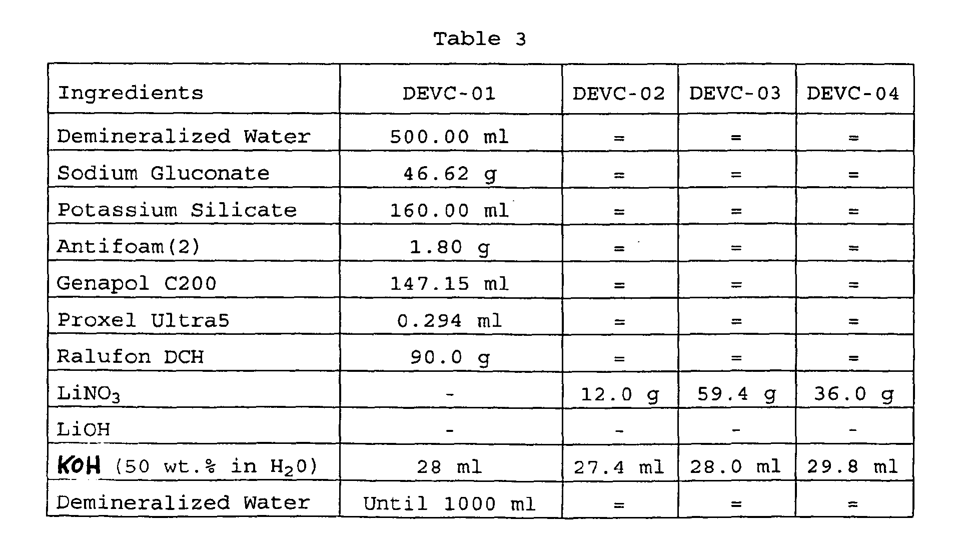

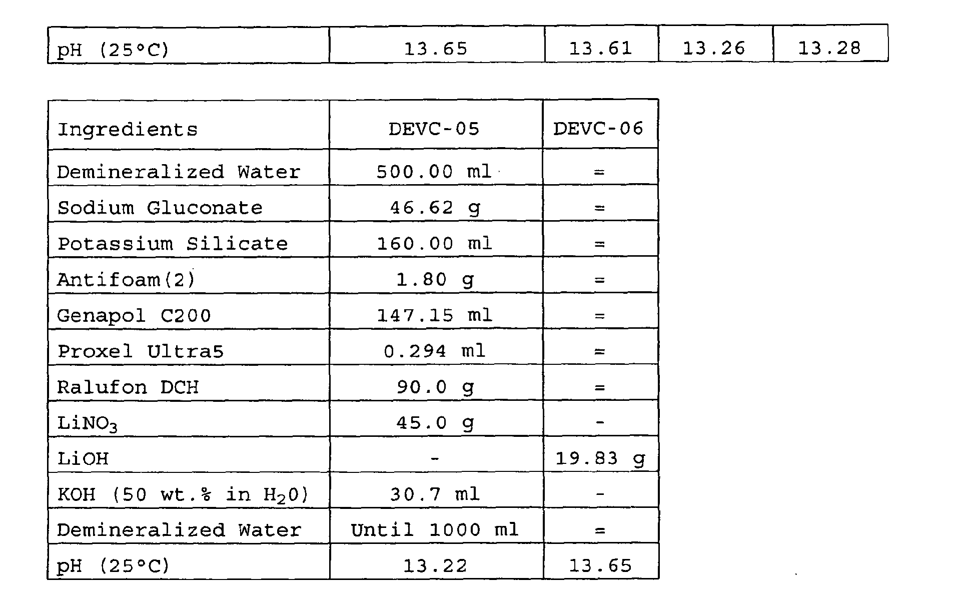

### Developing, exposing, printing and evaluation of the restart performance

:AMIGO printing plate precursors were exposed as described in Example 1. Development of the exposed precursors in the 1+8 diluted DEVC-01 to DEVC06, printing and evaluation of the restart performance was carried out as described in example 1. The results are shown in Table 4.

**Table 4**

| Developer | Restart performance | Lithium* (g/l) |
|---|---|---|
| DEVC-01 (COMP) | 0 | 0 |
| DEVC-02 (INV) | 3 | 0.13 |
| DEVC-03 (INV) | 4 | 0.66 |
| DEVC-04 (INV) | 4 | 0.40 |
| DEVC-05 (INV) | 4 | 0.50 |
| DEVC-06 (INV) | 4 | 0.63 |

| | | |
|---|---|---|
| * Lithium concentration of the 1+8 diluted developers | | |

It is clear from Table 4 that printing plates obtained by processing the precursor in developers containing at least 0.05 g/l lithium ions obtained from the inventive developer concentrates (DEVC-02 to DEVC-06) are characterized by a substantial improvement of the restart performance.

## Claims

1. A method for making a lithographic printing plate comprising the steps of:
(i) providing a lithographic printing plate precursor having a support with a hydrophilic surface or which is provided with a hydrophilic layer and a coating provided thereon, the coating comprising an image-recording layer which contains thermoplastic particles;
(ii) exposing the precursor to heat or infrared radiation;
(iii) developing the exposed precursor in an alkaline aqueous solution;
**characterized in that** the alkaline aqueous solution comprises at least 0.05 g/l of lithium ions.

2. The method according to claim 1 wherein the amount of lithium ions is at least 0.10 g/l.

3. The method according to claim 1 wherein the amount of lithium ions is at least 0.25 g/l.

4. The method according to any one of the preceding claims wherein the aqueous solution has a pH of at least 9.0.

5. The method according to any one of the preceding claims wherein the aqueous solution further comprises a mono alkali metal or ammonium salt of an organic carboxylic acid having 4 to 12 carbon atoms and substituted with 3 to 11 hydroxyl groups.

6. The method according to claim 5 wherein the organic carboxylic acid is gluconic acid.

7. The method according to claim 6 wherein the amount of gluconic acid is at least 0.08 mol/l.

8. The method according to any one of claims 6 or 7 wherein the molar ratio of lithium ions to gluconic acid is from 0.9 to 4.0.

9. The method according to any one of the preceding claims wherein the thermoplastic particles have an average particle diameter of from 25 to 55 nm.

10. A method of printing comprising the steps of:
(i) providing a printing plate obtained from the method as defined in any one of claims 1 to 9;
(ii)mounting the printing plate on a printing press;
(iii) supplying ink and fountain solution to the printing plate;
(iv) transferring the ink to paper.

## Patentansprüche

1. Ein Verfahren zur Herstellung einer lithografischen Druckplatte, das folgende Schritte umfasst :
(i) Bereitstellen einer Vorstufe einer lithografischen Druckplatte, die einen Träger mit einer hydrophilen Oberfläche oder einen mit einer hydrophilen Schicht versehenen Träger und eine auf den Träger angebrachte Beschichtung umfasst, wobei die Beschichtung eine thermoplastische Teilchen enthaltende Bildaufzeichnungsschicht umfasst,
(ii) Erwärmung oder Infrarotbelichtung der Vorstufe und
(iii) Entwicklung der erwärmten bzw. belichteten Vorstufe in einer wässrig-alkalischen Lösung,
**dadurch gekennzeichnet, dass** die wässrig-alkalische Lösung mindestens 0,05 g/l Lithiumionen enthält.

2. Verfahren nach Anspruch 1, **dadurch gekennzeichnet, dass** die Menge Lithiumionen mindestens 0,10 g/l beträgt.

3. Verfahren nach Anspruch 1, **dadurch gekennzeichnet, dass** die Menge Lithiumionen mindestens 0,25 g/l beträgt.

4. Verfahren nach einem der vorstehenden Ansprüche, **dadurch gekennzeichnet, dass** die wässrige Lösung einen pH-Wert von mindestens 9,0 aufweist.

5. Verfahren nach einem der vorstehenden Ansprüche, **dadurch gekennzeichnet, dass** die wässrige Lösung ferner ein Monoalkalimetallsalz oder Ammoniumsalz einer mit 3 bis 11 Hydroxylgruppen substituierten organischen Carbonsäure mit 4 bis 12 Kohlenstoffatomen enthält.

6. Verfahren nach Anspruch 5, **dadurch gekennzeichnet, dass** die organische Carbonsäure Gluconsäure ist.

7. Verfahren nach Anspruch 6, **dadurch gekennzeichnet, dass** die Menge Gluconsäure mindestens 0,08 Mol/l beträgt.

8. Verfahren nach einem der Ansprüche 6 oder 7, **dadurch gekennzeichnet, dass** das Molverhältnis von Lithiumionen zu Gluconsäure zwischen 0,9 und 4,0 liegt.

9. Verfahren nach einem der vorstehenden Ansprüche, **dadurch gekennzeichnet, dass** die thermoplastischen Teilchen eine mittlere Teilchengröße zwischen 25 und 55 nm aufweisen.

10. Ein Druckverfahren, das folgende Schritte umfasst :
(i) Bereitstellen einer nach dem gemäß einem der Ansprüche 1 bis 9 definierten Verfahren hergestellten Druckplatte,
(ii) Einspannen der Druckplatte in eine Druckmaschine,
(iii) Einfärben mit Drucktinte und Benetzen mit Feuchtwasser der Druckplatte und
(iv) Übertragen der Drucktinte auf Papier.

## Revendications

1. Un procédé pour la fabrication d'une plaque d'impression lithographique, comprenant les étapes ci-après :
(i) la mise à disposition d'un précurseur de plaque d'impression lithographique comprenant un support ayant une surface hydrophile ou un support revêtu d'une couche hydrophile et un revêtement appliqué sur le support et comprenant une couche d'enregistrement d'image contenant des particules thermoplastiques,
(ii) le chauffage ou l'exposition aux rayons infrarouges du précurseur et
(iii) le développement du précurseur chauffé ou exposé dans une solution alcaline aqueuse,
**caractérisé en ce que** la solution alcaline aqueuse contient au moins 0,05 g/l d'ions de lithium.

2. Procédé selon la revendication 1, **caractérisé en ce que** la quantité d'ions de lithium s'élève à au moins 0,10 g/l.

3. Procédé selon la revendication 1, **caractérisé en ce que** la quantité d'ions de lithium s'élève à au moins 0,25 g/l.

4. Procédé selon l'une quelconque des revendications précédentes, **caractérisé en ce que** la solution aqueuse présente une valeur de pH d'au moins 9,0.

5. Procédé selon l'une quelconque des revendications précédentes, **caractérisé en ce que** la solution aqueuse contient en outre un sel de métal mono-alcalin ou un sel d'ammonium d'un acide carboxylique organique substitué par 3 à 11 groupes hydroxyle et comprenant de 4 à 12 atomes de carbone.

6. Procédé selon la revendication 5, **caractérisé en ce que** l'acide carboxylique organique est l'acide gluconique.

7. Procédé selon la revendication 6, **caractérisé en ce que** la quantité d'acide gluconique s'élève à au moins 0,08 mole/l.

8. Procédé selon l'une quelconque des revendications précédentes 6 ou 7, **caractérisé en ce que** le rapport molaire des ions de lithium à l'acide gluconique est compris entre 0,9 et 4,0.

9. Procédé selon l'une quelconque des revendications précédentes, **caractérisé en ce que** les particules thermoplastiques présentent une grandeur de particule moyenne comprise entre 25 et 55 nm.

10. Un procédé d'impression comprenant les étapes ci-après :
(i) la mise à disposition d'une plaque d'impression confectionnée selon le procédé tel que défini selon l'une quelconque des revendications 1 à 9,
(ii) le serrage de la plaque d'impression dans une machine à imprimer,
(iii) l'encrage de la plaque avec une encre d'impression et le mouillage de la plaque avec une solution de mouillage et
(iv) le transfert de l'encre sur du papier.
